Europäisches Patentamt

European Patent Office

Office européen des brevets

(11) Veröffentlichungsnummer: **0 141 050**
**B1**

(12) # EUROPÄISCHE PATENTSCHRIFT

(45) Veröffentlichungstag der Patentschrift:
04.11.87

(51) Int. Cl.⁴: **G 01 R 31/00,** G 01 R 1/28

(21) Anmeldenummer: **84108477.5**

(22) Anmeldetag: **18.07.84**

(54) **Elektrische Prüfeinrichtung eines Fahrzeug-Kombinationsinstruments.**

(30) Priorität: **06.09.83 DE 3332386**

(43) Veröffentlichungstag der Anmeldung:
**15.05.85 Patentblatt 85/20**

(45) Bekanntmachung des Hinweises auf die Patenterteilung:
**04.11.87 Patentblatt 87/45**

(84) Benannte Vertragsstaaten:
**DE FR GB IT**

(56) Entgegenhaltungen:
**DD-A-210 994**

(73) Patentinhaber: **VDO Adolf Schindling AG,
Gräfstrasse 103, D-6000 Frankfurt/Main (DE)**

(72) Erfinder: **Brüggemann, Ulrich, Dipl.- Ing.,
Neurothstrasse 2, D-6370 Oberursel (DE)**

(74) Vertreter: **Könekamp, Herbert, Dipl.- Ing., Sodener
Strasse 9, D-6231 Schwalbach (DE)**

EP 0 141 050 B1

## Beschreibung

Die Erfindung betrifft eine elektrische Prüfeinrichtung eines Fahrzeug-Kombinationsinstruments nach dem Oberbegriff des Anspruchs 1.

Bei der zum Stand der Technik gehörenden Prüfung analog anzeigender Zeigerinstrumente für Fahrzeuge, insbesondere Kraftfahrzeuge wird das Zeigerinstrument mit einem bestimmten Signal entsprechend einem simulierten Meßwert beaufschlagt und festgestellt, ob ein entsprechender Anzeigewert erreicht wird.

Fahrzeug-Kombinationsinstrumente mit aus Segmenten bestehenden Anzeigemitteln, die insbesondere durch Flüssigkristallzellen gebildet sind, lassen sich in dieser Weise nicht ohne weiteres überprüfen. Hierbei müssen die Schaltpunkte der Segmente bei bestimmten Meßwerten überprüft werden. Wenn die Meßwerte durch Widerstandswerte eines Widerstandsgebers für die Füllstandmessung, Temperaturmessung oder Druckmessung dargestellt sind, muß die Prüfung in herkömmlicher Weise mit hochgenauen Widerstandsdekaden erfolgen, die an die Eingänge des Fahrzeug-Kombinationsinstruments anstelle der Meßgeber angeschlossen werden. Die Prüfeinrichtung mit solchen hochgenauen Widerstandsdekaden, die außerdem alterungsbeständig sein müssen und für eine relativ hohe Verlustleistung bemessen sein müssen, ist aber aufwendig. Abgesehen davon ist die mit einer solchen Prüfeinrichtung durchzuführende Endprüfung der Fahrzeug-Kombinationsinstrumente nach deren Fertigung umständlich und zeitraubend, was auf die Einstellung der Dekaden und darauf zurückzuführen ist, daß wegen der vorgesehenen Dämpfung vieler Anzeigen des Fahrzeug-Kombinationsinstruments nach jeder Veränderung der Einstellung eine erhebliche Zeit abgewartet werden muß, bis die entsprechende Anzeige ausgewertet werden kann.

Außerdem eignet sich diese Prüfeinrichtung mit Widerstandsdekaden nicht dazu, andere Fehler eines Fahrzeug-Kombinationsinstruments mit aus Segmenten bestehenden Anzeigemitteln zuverlässig festzustellen, insbesondere Nebenschlüsse zwischen den Segmenten, deren Steuerleitungen oder Treiberanschlüssen zu erkennen. Ein Segment wird durch einen solchen Nebenschluß auch dann aktiviert, wenn es bei einer bestimmten Konfiguration der Anzeige durch die Anzeigesteuerung inaktiv bleiben sollte.

Zu der vorliegenden Erfindung gehört daher die Aufgabe, eine elektrische Prüfeinrichtung für Fahrzeug-Kombinationsinstrumente mit den im Oberbegriff des Anspruchs 1 angegebenen Merkmalen zu schaffen, welches wenig aufwendig ist, eine rasche und zuverlässige Prüfung von Eingangsschaltungen mit Eingangsnetzwerken und Analog-Digitalwandlern sowie eine Prüfung auf unerwünschte Nebenschlüsse der einzelnen Segmente gestattet.

Diese Aufgabe wird durch die in dem kennzeichnenden Teil des Anspruchs 1 angegebene Erfindung gelöst.

Erfindungsgemäß wird zur Überprüfung der Eingangsschaltung der Kombinationsinstrumente für jeden Meßwerteingang, der nach dem späteren Einbau des Kombinationsinstruments in das Fahrzeug an einen Widerstandsmeßgeber anzuschließen ist, zur Endprüfung ein einen kritischen Meßwert simulierender Ersatzwiderstand angekoppelt. In dem Mikrocomputer jedes Kombinationsinstruments sind Toleranzwerte oder Grenzwerte gespeichert, die der Ersatzwiderstand in Verbindung mit der Eingangsschaltung - Eingangsnetzwerk und Analog-Digitalwandler - erreichen, aber nicht überschreiten darf. Da der Ersatzwiderstand in der Prüfeinrichtung fest vorgegeben ist, läßt sich so auf die Eigenschaften des Eingangsnetzwerks des Analog-Digitalumsetzers und weiterer Schaltelemente der Eingangsschaltung schließen. Der Mikrocomputer überträgt je nach dem Vergleichsergebnis, ob der Widerstandswert der Eingangsschaltkreise innerhalb der Toleranzen liegt oder nicht, einen von gespeicherten charakteristischen Anzeigewerten auf die Anzeigemittel.

Vorzugsweise werden die Anzeigewerte als Zahl auf den zur Geschwindigkeitsanzeige eingerichteten Anzeigemitteln dargestellt. Der Anzeigewert kann aber auch in anderer Weise repräsentiert werden, beispielsweise im Fehlerfall durch Blinken der entsprechenden Anzeigesegmente.

In der geschilderten Endprüfphase ist also festgestellt worden, ob die Bitkombinationen zu den simulierten Meßwiderständen, die von dem Analog-Digitalwandler abgefragt werden, Maximum- und Minimumgrenzwerte, die in dem Mikrocomputer gespeichert sind, überschreiten, unterschreiten oder ordnungsgemäß zwischen diesen liegen. Damit werden der Wandlerfehler sowie Fehler des vorgeschalteten Widerstandsnetzwerks neben der Toleranz des den Geber simulierenden Widerstands erfaßt. Durch weitere manuelle Betätigung eines Schalters der Prüfeinrichtung werden etwaige Nebenschlüsse der Segmente, der Segmentsteuerleitungen und der Treiberanschlüsse erfaßt. Hierzu werden in mehreren Endprüfphasen durch die Anzeigesteuerung aufeinanderfolgend fest vorgegebene Segmentkombinationen aktiviert. Es werden solche Kombinationen aktiviert, daß diese bei ordnungsgemäßer Funktion durch einen Prüfer leicht erkannt werden können und daß nie zwei nebeneinander liegende Segmente bzw. Segmentbahnen mit einem gleichphasigen Signal beaufschlagt werden.

Als besonders einprägsam für die Prüfperson haben sich drei Segmentkombinationen erwiesen, die in verschiedenen Endprüfphasen erreicht werden:

1. Es werden alle ungradzahligen Segmente für Anzeigemittel für die Drehzahl in der Art einer Bargraph-Anzeige sowie die waagerechten Segmente einer digitalen Geschwindigkeits anzeige angesteuert.

2. Es werden alle geradzahligen Segmente der Drehzahlanzeigemittel, die oberen senkrechten Segmente der Geschwindigkeitsanzeige und die Einheit km/h angesteuert.

3. Es werden die restlichen unteren Segmente der Geschwindigkeitsanzeige und alle übrigen Maßeinheiten, Symbole und Beschriftungen des Kombinationsinstrumentes aktiviert.

Nach Ablauf dieser Endprüfphasen ist der Mikrocomputer des Kombinationsinstruments in Verbindung mit einer Überwachungsschaltung intern selbsttätig auf normale Betriebsart umschaltbar. Bei dieser normalen Betriebsart, die aber noch zur Endprüfung gehört, werden durch Impulsgeber. die vorzugsweise von einer Netzfrequenz abgeleitete Impulse aus der Prüfeinrichtung als Wegimpulse und Drehzahlimpulse in das Kombinationsinstrument eingespeist. In der normalen Betriebsart laufen dabei die Anzeigemittel für die Drehzahlanzeige in der Art einer Bargraph-Darstellung hoch, desgleichen zählt der Wegstreckenzähler.

Danach beginnt der Programmablauf in dem Mikrocomputer neu und der Prüfvorgang kann erforderlichenfalls wiederholt werden.

Die Erfindung wird im folgenden anhand einer Zeichnung mit zwei Figuren erläutert. Es zeigen:

Fig. 1 das einer Endprüfung zu unterwerfende elektronische Kombinationsinstrument in einem Blockschaltbild,

Fig. 2 ein Schaltbild der für die Endprüfung des Kombinationsinstruments geeigneten Prüfeinrichtung und

Fig. 3a, 3b, 3c, 3d die Anzeigemittel des Kombinationsprüfgeräts in verschiedener Endprüfphase.

In der folgenden Beschreibung wird mehrfach auf die in der Kraftfahrzeugtechnik übliche Bezeichnung von Anschlußklemmen Bezug genommen.

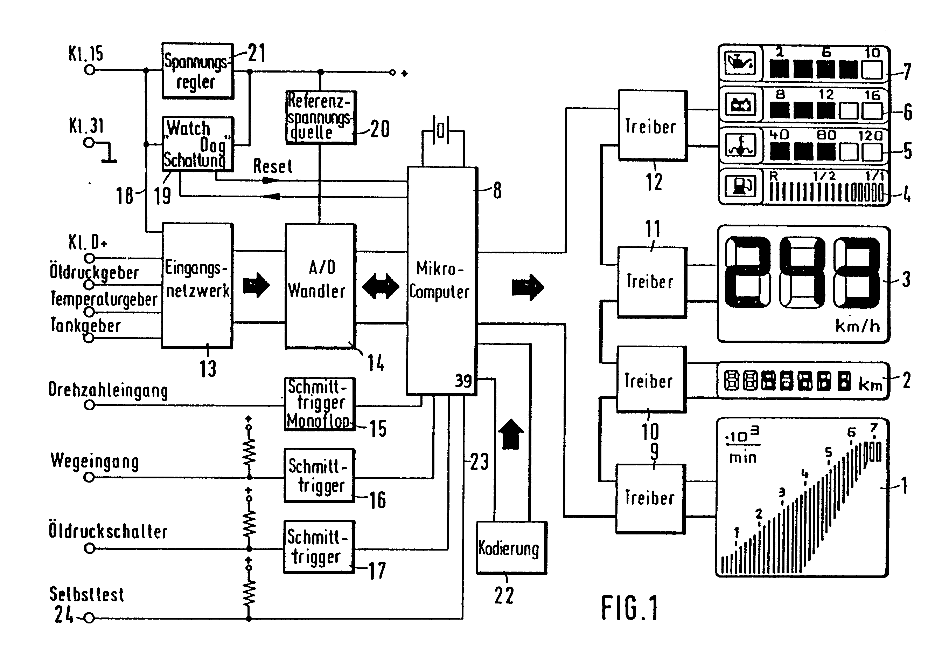

Gemäß Fig. 1 gehört zu der Anzeigeeinrichtung eine Bargraph-Anzeige 1 zur Anzeige der Drehzahl eines Kraftfahrzeugs, ein Wegstreckenzähler 2, eine Geschwindigkeits- bzw. Tachometeranzeige 3 sowie vier mit Segmenten bzw. in der Art einer Bargraphanzeige aufgebaute Darstellungen 4-7 für Tankfüllstand, Wassertemperatur, Batteriespannung, Öldruck.

Sämtliche Anzeigen einschließlich der Dimensionsangabe und Symbole für die Meßgrößen sind mit Flüssigkeitskristallen aufgebaut.

Die Segmente dieser Flüssigkeitskristalle werden von einem Mikrocomputer 8 über Treiber 9-12 angesteuert.

Die Ansteuerung der dargestellten Anzeigemittel erfolgt entsprechend den Meßgrößen, die für den Füllstand, die Wassertemperatur, den Öldruck und die Spannung über ein anpassendes Eingangsnetzwerk 13 und einen Analog-Digitalwandler 14 in den Mikrocomputer eingespeist werden. Die Meßgrößen für die Drehzahl, die Wegstrecke und die Geschwindigkeit werden über einen Schmitt-Trigger und Monoflop 15 bzw. über einen Schmitt-Trigger 16 in den Mikrocomputer eingespeist.

Ein Signal von einem Öldruckschalter wird über einen Schmitt-Trigger 17 dem Mikrocomputer zugeleitet. Außerdem wird der Mikrocomputer von der 'Klemme 15' des Kraftfahrzeugses (Kl. 15) über eine Leitung 18 das Eingangsnetzwerk 13 und den Analog-Digitalwandler 14 angesteuert. Damit kann der Mikrocomputer zunächst nach Einschalten der Zündung in einer Prüfphase in der Prüfbetriebsart betrieben werden, in der alle Segmente der Anzeigemittel 1-7 angesteuert werden, um dem Fahrer darzustellen, daß alle Segmente, insbesondere die der Warnfunktionen in Ordnung sind. Die Segmente der Geschwindigkeitsanzeige werden dabei in zwei Abschnitten angezeigt, und zwar zunächst in einer charakteristischen kleineren Zahl und dann mit einer zweiten Zahl, die alle benutzbaren Segmente als Ziffernfolge angibt, etwa 288 (bei der in Ziffer 2 zusätzlich ein Segment der "1"- Darstellung ansteuerbar ist).

Beispielsweise durch den Öldruckschalter kann von dieser Prüfphase vorzeitig in die Betriebsart zur Darstellung der aktuellen Meßwerte umgeschaltet werden.

Zu der Anzeigeeinrichtung gehört ferner eine Überwachungsschaltung 19, die den ordnungsgemäßen Programmablauf des Mikrocomputers 8 überwacht und anderenfalls den Mikrocomputer zurückstellt (Reset). Zum Betrieb des Analog-Digitalwandlers ist eine Referenzspannungsquelle 20 vorgesehen.

Die Überwachungsschaltung und die Referenzspannungsquelle werden von einem Spannungsregler 21 gespeist.

Weiterhin gehören zu der Anzeigeeinrichtung Codierschalter 22, die als Umschaltmittel zur Anpassung des Mikrocomputers bei der Drehzahlimpulsverarbeitung an den jeweiligen Motortyp dienen.

Schließlich ist eine aus dem Mikrocomputer herausgeführte Leitung 23 vorgesehen, die zu einem Anschluß 24 für die Durchführung eines Werkstattests dient.

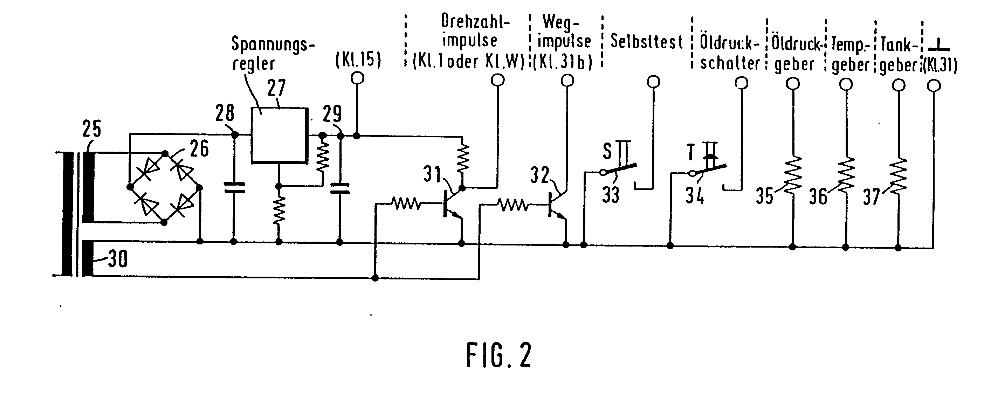

Zu der Endprüfung des Kombinationsinstruments in Fig. 1 sind die in der Zeichnung links dargestellten Klemmen noch nicht mit den entsprechenden Anschlüssen eines Fahrzeugs, insbesondere den Gebern, verbunden sondern sie sind zur Endprüfung an entsprechend bezeichneten Klemmen der Prüfeinrichtung nach Fig. 2 anschließbar.

Die Prüfeinrichtung umfaßt ein Netzgerät mit einem Transformator 25, einem Gleichrichter 26, einem Spannungsregler 27 und Glättungskondensatoren 28, 29, welches eine geregelte Spannung von 13,5 V an eine Klemme abgibt, die der Klemme 15 (Kl. 15) in Fig. 1 entspricht.

Eine Wicklung 30 des Transformators 25 dient zur Steuerung von Transistoren 31, 32, die je einen Impulsgeber für Drehzahlimpulse und Wegimpulse bilden. Die Drehzahlimpulse und Wegimpulse sind an entsprechend bezeichneten Klemmen abnehmbar.

Weiter umfaßt die Prüfeinrichtung einen Schalter 33, der mit dem Anschluß 24 in Fig. 1 verbindbar ist und den Mikrocomputer in die Endprüfbetriebsart schaltet.

Ein Taster 34 liegt an dem in dieser Prüfbetriebsphase im übrigen funktionslosen Anschluß für den Öldruckschalter, um die einzelnen Endprüfphasen in dem Mikrocomputer 8 manuell anzusteuern.

Weiterhin umfaßt die Prüfeinrichtung hochgenaue Ersatzwiderstände 35-37, die Widerstandsgeber für Öldruck, Temperatur und Tankfüllstand ersetzen. Der letzte Anschluß dieser Reihe Klemme 31' (Kl. 31) dient zum Anschluß des Masseleiters an das Kombinationsinstrument.

Zu der Endprüfung ist in den Mikrocomputer ein Testprogramm einprogrammiert. Das Testprogramm umfaßt die Größt- und Kleinstwerte für die simulierten Meßwerte des Öldrucks, der Temperatur und des Tankfüllstands. An einem Pin 39, der mit dem Anschluß 24 in Verbindung steht, ist der Endtest initiierbar. Durch einen weiteren Pin am Mikrocomputer, der nach Einbau des Kombinationsinstruments für den Öldruckschalter vorgesehen ist, steht der Taster 34 zum Weiterschalten der einzelnen Endprüfphasen in Verbindung. Die Organisation des Mikrocomputers für die einzelnen Endprüfphasen ergibt sich aus der vorangehenden allgemeinen Beschreibung und aus dem nachfolgend beschriebenen Testablauf. Der Mikrocomputer ist jedoch so eingerichtet, daß nach einer vorbestimmten Endprüfphase der Mikrocomputer keinen Impuls zu der Überwachungsschaltung 19 abgibt, so daß diese Überwachungsschaltung durch einen Rücksetzimpuls (Reset) den Mikrocomputer in die normale Betriebsart umschaltet, in der - noch während der Endprüfung - die von den Transistoren 31 und 32 gebildeten Drehzahlimpulse und Wegimpulse zu Prüfzwecken erfaßt und angezeigt werden.

Zunächst werden die Anschlüsse des Testgeräts mit den gleich bezeichneten Anschlüssen des Kombinationsinstruments verbunden, so daß insbesondere die Masseverbindung hergestellt ist und die drei Ersatzwiderstände 35-37 die entsprechenden Geberwiderstände ersetzen. Anschließend wird die Versorgungsspannung mit dem Netzteil 25 eingeschaltet. Durch Betätigen des Schalters 33 wird der Pin 39 des Mikrocomputers auf Masse gelegt. Diese Verbindung muß schon beim Einschalten des Kombinationsinstruments vorliegen, da der Pin 39 nur einmal nach dem Rücksetzen des Mikrocomputers abgefragt wird.

Hierdurch wird vermieden, daß ein späteres Störsignal den Mikrocomputer in die Endprüfbetriebsart schalten kann.

Der Mikrocomputer überprüft nun in der ersten Endprüfphase die Eingänge des Analog-Digitalwandlers, mit denen die Ersatzwiderstände 35-37 für das Eingangsnetzwerk 13 in Verbindung stehen. Treten bei diesem Überprüfen der Eingangsschaltungen Fehler auf, so wird deren Summe auf den Geschwindigkeitsanzeigemitteln 3 durch die Ziffern 1-15 mit folgender Zuordnung angezeigt:

8 = Öldruck
4 = Spannung
2 = Temperatur
1 = Tankfüllstand
0 = kein Fehler

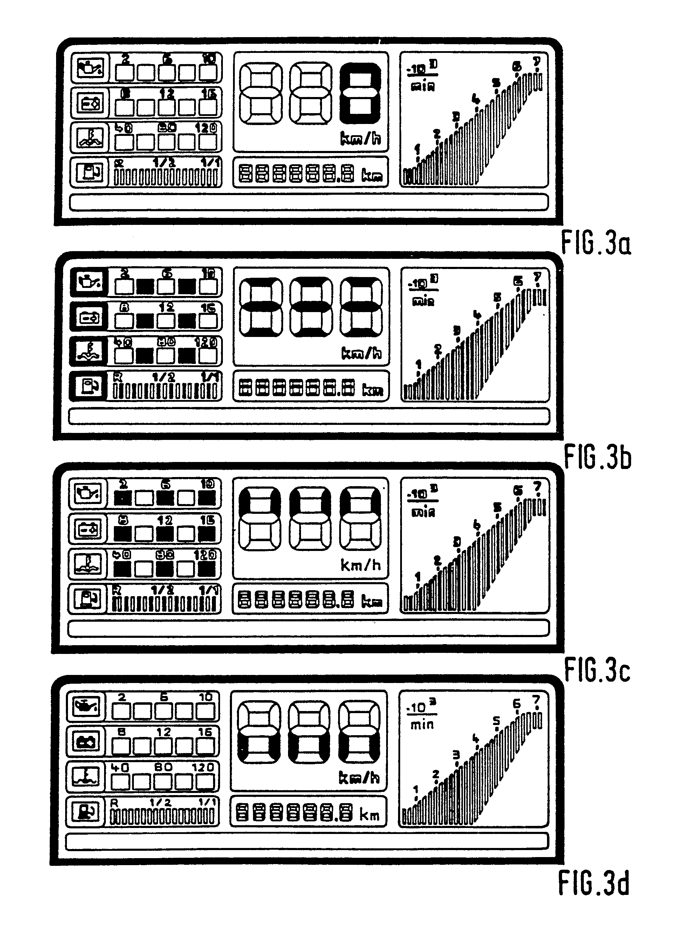

Das Prüfergebnis "kein Fehler" ist in Fig. 3a dargestellt.

Nachdem die Eingänge des Analog-Digitalwandlers in der geschilderten Weise überprüft wurde, lassen sich die einzelnen weiteren Endprüfphasen durch den Taster 34 weiterschalten:

Beim ersten Betätigen des Tasters 34 wird in dem Mikrocomputer 8 das erste Testbild als Segmentkombination gemäß Fig. 3b generiert.

Nach Überprüfung dieses Testbildes durch die Prüfperson wird erneut der Taster 34 kurzfristig betätigt, wodurch das zweite Testbild gemäß Fig. 3c aktiviert wird. Schließlich wird durch erneutes Betätigen des Tasters 34 das Testbild 3d hervorgerufen.

Nachdem die drei genannten Endprüfphasen zur Darstellung der ordnungsgemäßen Segmentansteuerung abgelaufen sind, sendet der Mikrocomputer bei einem erneuten Betätigen des Tasters 34 keinen Impuls zu der Überwachungsschaltung 19 mehr aus. Damit wird bei ordnungsgemäßer Wirkung der Überwachungsschaltung 19 ein Rücksetzimpuls (Reset) nach kurzer Zeit ausgelöst, wodurch zugleich diese Schaltungsanordnung überprüft ist.

Ist die Masseverbindung am Pin 39 durch den Schalter 33 unterbrochen, so liegt die normale Betriebsart des Kombinationsinstruments vor, während im anderen Falle erneut die Endprüfung beginnt. Wenn der Mikrocomputer von der Endprüfbetriebsart in die normale Betriebsart übergeht, werden der Tachometer, der Wegstreckenzähler und der Drehzahlmesser durch Einspeisen der Wegimpulse und Drehzahlimpulse aus der Prüfeinrichtung überprüfbar. Anschließend ist der Test beendet. Wenn die Überwachungsschaltung und Rücksetzschaltung hingegen nicht in Ordnung sind, bleibt das dritte Display-Testbild nach Fig. 3d weiterhin angezeigt, bis die Spannungsversorgung des Kombinationsinstruments ausgeschaltet wird.

**Patentansprüche**

1. Elektrische Prüfeinrichtung für Fahrzeug-Kombinationsinstrumente, die aus Segmenten bestehende Anzeigemittel (1 bis 7), eine Anzeigesteuerung in einem Mikrocomputer (8) zur Aktivierung der Segmente in Abhängigkeit von Meßwerten, für analoge Meßwerte einen der Anzeigesteuerung vorgeschalteten Analog-Digitalwandler (14) sowie gegebenenfalls ein diesem vorgeschaltetes Eingangsnetzwerk (13) aufweisen, dadurch gekennzeichnet, daß in dem Mikrocomputer (8) für jede Meßgröße Toleranzwerte eines kritischen Anzeigewertes gespeichert sind, die in einer ersten Endprüfphase einer manuell ansteuerbaren Endprüfbetriebsart mit einem simulierten Meßwert, der über den Analog-Digitalwandler (14) und gegebenenfalls das Eingangsnetzwerk (13) in den Mikrocomputer einspeisbar ist, verglichen wird, daß ein in dem Mikrocomputer (8) gespeicherter, das Vergleichsergebnis repräsentierender Anzeigewert in Abhängigkeit von dem Vergleichsergebnis auf die Anzeigemittel (1 bis 7) übertragbar ist, daß durch die Anzeigesteuerung aufeinanderfolgend fest vorgegebene Segmentkombinationen in weiteren, manuell ansteuerbaren Endprüfphasen in Prüfbetriebsart aktivierbar sind, und daß in der Prüfeinrichtung den Meßwert simulierende Ersatzwiderstände (35 - 37) sowie Schalter (33, 34) zum Aufrufen der Endprüfbetriebsart und Weiterschalten der Endprüfphasen vorgesehen sind.

2. Prüfeinrichtung nach Anspruch 1, dadurch gekennzeichnet, daß in der Prüfeinrichtung (Fig. 2) Impulsgeber (30, 31, 32) für Wegimpulse und Drehzahlimpulse vorgesehen sind, die zur Prüfung des Wegstreckenzählers (2) und des Drehzahlmessers (1) in der normalen Betriebsart des Kombinationsinstruments in den Mikrocomputer (8) einspeisbar sind.

3. Prüfeinrichtung nach Anspruch 1 und 2, dadurch gekennzeichnet, daß der Mikrocomputer (8) des Kombinationsinstruments in Verbindung mit einer Überwachungsschaltung (19) zur Umschaltung von der Endprüfbetriebsart auf normale Betriebsart nach einer vorgegebenen Anzahl Endprüfphasen eingerichtet ist, so daß dann die Prüfung des Wegstreckenzählers (2) und des Drehzahlmessers (1) erfolgt.

4. Prüfeinrichtung nach Anspruch 1, dadurch gekennzeichnet, daß mindestens ein das Vergleichergebnis repräsentierender Anzeigewert als Zahl auf den zur die Geschwindigkeitsanzeige (3) eingerichteten Anzeigemitteln darstellbar ist.

5. Prüfeinrichtung nach Anspruch 1 und 4, dadurch gekennzeichnet, daß eine Anzahl von Anzeigewerten (z. B. 0, 1, 2, 4, 8) die sämtlichen während einer Endprüfphase erzielten Vergleichsergebnisse repräsentiert, als Summe darstellbar sind.

**Claims**

1. Electrical testing device for combination instruments in vehicles which comprise display means (1 to 7) consisting of segments, a display control in a microcomputer (8) for actuation of the segments in dependence on measurement values, for analog measurement values an analog-todigital converter (14) preceding the display control, and also possibly an input network (13) preceding the said converter, characterised in that there are stored in the microcomputer (8) tolerance values of a critical display value for each measurement quantity which is compared in a first end test phase of a manually actuatable end test operation mode with a simulated measurement value adapted to be fed into the microcomputer through the agency of the analog-to-digital converter (14) and the input network (13) where appropriate, that a display value representing the comparison result and stored in the microcomputer (8) is transmittable to the display means (1 to 7) in dependence on the comparison result, that by means of the display control fixedly preset segment combinations can successively be actuated in further manually actuatable end test phases in a test operation mode, and that in the testing device there are provided equivalent resistances (35 - 37) simulating the measurenent value and also switches (33, 34) for calling-in the end test operation mode and for further switching of the end test phases.

2. Testing device according to claim 1, characterised in that pulse generators (30, 31, 32) are provided in the testing device (Fig. 2) for travel pulses and speed pulses which are adapted to be fed into the microcomputer (8) for testing the mileage indicator (2) and the speed indicator (1) in the normal operation mode of the combination instrument.

3. Testing device according to claims 1 and 2. characterised in that the microcomputer (8) of the combination instrument in conjunction with a monitoring circuit (19) is adapted to change over from the end test operation mode to normal operation mode after a predetermined number of end test phases, so that the testing of the mileage indicator (2) and of the speed indicator (1) is then carried out.

4. Testing device according to claim 1, characterised in that at least one display value representing the comparison result is representable as a number on the display means (3) which are adapted to indicate speed.

5. Testing device according to claims 1 and 4, characterised in that a number of display values (e.g. 0, 1, 2, 4, 8) representing all the comparison results achieved during an end test phase are representable as a sum.

## Revendications

1. Dispositif de vérification électrique d'un instrument combiné pour véhicules, qui présente des moyens d'affichage (1 à 7) composés de segments, un dispositif de commande d'affichage dans un microprocesseur (8) destiné à l'activation des segments en fonction de valeurs de mesure, dans le cas de valeurs de mesures analogiques un convertisseur (14) analogique-numérique branché en amont du dispositif de commande d'affichage ainsi que, le cas échéant, un ensemble d'entrée (13) monté en amont de ce dernier et raccordé au secteur d'entrée (13), dispositif caractérisé en ce que, pour chaque grandeur mesurée, des valeurs de tolérances correspondant à une valeur critique d'affichage sont mises en mémoire dans le microprocesseur (8), la valeur critique d'affichage étant comparée dans une première phase de vérification finale d'un mode de fonctionnement de vérification finale qui peut être commandé manuellement, avec une valeur de mesure simulée qui peut être introduite dans le microprocesseur par l'intermédiaire du convertisseur (14) analogique-numérique et, le cas échéant, par l'ensemble (13) d'entrée raccordé au secteur; en ce qu'une valeur d'affichage, mise en mémoire dans le microprocesseur (8), et représentant le résultat de la comparaison, peut être transférée en fonction du résultat de la comparaison sur les moyens (1 à 7) d'affichage; en ce que des combinaisons de segments déterminées à l'avance peuvent être activées l'une après l'autre au cours de phases manuelles ultérieures de vérification; finale, en mode de fonctionnement de vérification et en ce que des résistances (35-37) de remplacement, simulant la valeur de mesure, ainsi que des commutateurs (33-34) destinés à la mise sur le mode de fonctionnement de vérification finale à la commutation ultérieure sur les phases de vérification finale, sont prévus dans le dispositif de vérification.

2. Dispositif de vérification selon la revendication 1, caractérisé en ce que des émetteurs (30, 31, 32) d'impulsions d'indication de distance parcourue et de nombre de tours sont prévus dans le dispositif de vérification (figure 2), ces impulsions pouvant être introduites dans le microprocesseur (8) pour la vérification du compteur (2) de distance parcourue et du compte-tours (1) en mode de fonctionnement normal de l'instrument combiné.

3. Dispositif de vérification selon les revendications 1 et 2, caractérisé en ce que le microprocesseur (8) de l'instrument combiné est relié à un circuit (19) de surveillance pour le passage du mode de fonctionnement de vérification finale au mode de fonctionnement normal après un nombre fixé à l'avance de phases de vérification finale, si bien qu'ensuite on peut procéder à la vérification du compteur (2) de distance parcourue et du compte-tours (1).

4. Dispositif de vérification selon la revendication 1, caractérisé en ce qu'au moins une valeur d'affichage représentant le résultat de la comparaison peut être présentée en tant que nombre sur les moyens (3) mis en place pour l'affichage de la vitesse.

5. Dispositif de vérification selon l'une des revendications 1 à 4, caractérisé en ce qu'un certain nombre de valeurs d'affichage (par exemple 0, 1, 2, 4, 8) représentant l'ensemble des résultats de comparaison obtenus pendant une phase de vérification finale, peuvent être présentés sous forme de somme.

FIG.1

FIG. 2

0 141 050

FIG.3a

FIG.3b

FIG.3c

FIG.3d